# DEMANDE DE BREVET EUROPEEN

(11) **EP 1 331 602 A2**
(43) Date de publication de la demande: **30.07.2003**
(21) Numéro de dépôt: 03008639.1
(22) Date de dépôt: 14.02.1995
(51) Int. Cl.: G06K 19/077

(54) **Carte hybride à antenne et équipement de fabrication**

(30) Priorité: 14.02.1994 FR 9401652
(62) Demande divisionnaire de: 95400305.9
(71) Demandeur: GEMPLUS, 13420 Gémenos (FR)
(72) Inventeur: Fidalgo, Jean-Christophe, 13420 Gemenos (FR)

(57) **Abrégé**

Une Carte (1) sans contact possède : un corps (2) de carte ; un module électronique (7) qui comprend une puce (8) à circuit intégré et des plages de contact (12) ; et une antenne (5) avec des bornes de contact (15) et reliée aux plages (12) par l'intermédiaire de ces bornes (15). Une cavité (17) est ménagée dans le corps (2) et laisse apparaître les bornes (12) de l'antenne (5) ; le module (7) étant reporté dans la cavité (17). Un équipement pour fabriquer cette carte (1) est aussi décrit.

## Description

L'invention concerne une carte sans contact comportant un corps de carte, un module électronique et, connectée à ce module, une antenne. Ces cartes sont destinées à la réalisation d'opérations par exemple de débit dans des véhicules de transport en commun, bancaires, téléphoniques ou d'identification. Ces opérations s'effectuent grâce à un couplage électromagnétique à distance entre le module et un lecteur, en mode lecture / écriture.

L'invention concerne en outre des cartes mixtes, qui ont la possibilité de fonctionner sans contact et par contacts.

Actuellement, les cartes sont des objets portables aux dimensions normalisées souvent selon la norme ISO7810 correspond à un format de 85 mm de longueur, de 54 mm de largeur et de 0,76 mm d'épaisseur. Chaque carte sans contact comporte un corps constitué d'un assemblage de feuilles thermoplastiques et d'un module électronique comprenant une puce à circuit intégré. Une antenne du type bobine d'inductance est connectée à la puce. Les cartes sans contact mixtes comportent en outre une interface à contact constituée par des plots superficiels formant métallisations. Ces plots sont connectés à la puce.

On réalise des cartes sans contact par colamination, qui consiste à disposer entre deux plateaux d'une presse un empilement de feuilles thermoplastiques au milieu duquel on positionne le module déjà connecté à une antenne qui l'entoure. On effectue ensuite le soudage des différentes feuilles thermoplastiques en appliquant pression et température.

Du fait des déformations résiduelles des résistances différentielles aux chocs et aux torsions sont créées. La carte obtenue n'est pas esthétique, à moins d'augmenter son épaisseur.

Dans le cas d'une carte mixte, le positionnement de l'interface à contacts dans le corps de carte n'est souvent pas suffisamment précis pour permettre sa connexion convenable et automatisée. En plus, comme les cartes rejetées contiennent le module et la bobine, ce rejet est coûteux.

On réalise des cartes sans contact par dépôt d'un cadre rectangulaire sur une feuille thermoplastique inférieure ; dépôt d'un module connecté à une antenne, à l'intérieur d'une cavité formée par le cadre et la feuille intérieure ; puis en coulant une résine thermodurcissable dans cette cavité, avant la recouvrir d'une feuille thermoplastique supérieure.

Les cartes ainsi réalisées présentent sur la tranche une bande sinusoïdale inesthétique.

De plus, le positionnement ou report du module est approximatif, et il est donc difficile d'ajouter une interface à contact.

L'invention a pour but d'obtenir aisément des cartes esthétiques de faible épaisseur, avec un bon rendement, à un moindre coût, et en minimisant l'imprécision du report du module dans le corps de carte.

L'invention est définie dans les revendications. Citons ici des documents du domaine de l'invention.

Le document DE4105869 décrit une carte hybride comportant un corps, un module avec une puce, et plusieurs plages de contact, ainsi qu'une antenne reliée aux plages de contact du module par l'intermédiaire de deux bornes de contact. Le module comporte en outre des plots de contact pour un fonctionnement par contact.

Le document EP0570062 décrit un corps ayant suivant son épaisseur trois couches comportant des évidements qui permettent après assemblage de ces couches, la formation d'une cavité d'introduction d'un module. La cavité permet aussi l'enroulement d'un fil d'antenne.

Le document FR2659767 décrit deux bornes de connexion auxquelles une puce est connectée par des fils.

Le document JP04008395 décrit la détection de haute précision d'une quantité sans relation avec une fréquence d'alimentation en énergie, par application d'une pluralité de d'impulsion de valeur donnée, différentes l'une de l'autre vis-à-vis de la fréquence d'alimentation, et une valeur d'élévation entre des impulsions dans une période de tension terminale de condensateur.

Le document JP04321190 décrit comment ajuster une fréquence de résonance même après que les parties d'un circuit aient été montées sur un substrat. Une bobine contient une bobine principale en spirale, et des motifs d'ajustement qui sont coupés ou maintenus au besoin. En conséquence, l'inductance de la bobine peut être ajustée.

Le document JP05050529 décrit une structure composite. Un actionneur de fabrication du dispositif, est mis en contact avec le corps principal moulé, en intégrant à coeur un remplissage sous pression.

Le document JP06076132 décrit une carte sans contact qui reçoit une alimentation en puissance d'un équipement externe, via une antenne et qui répond au signal reçu d'une autre antenne via l'antenne. La carte sert aussi de carte de type à contact qui répond par un bornier de contact sur la surface de carte. Quand le contenu d'une mémoire est correctement inscrit, la carte peut aussi servir à un système de commande complexe.

Le document JP62002806 décrit une inspection de ligne de distribution supérieure, par plan modèle.

Le document US4674175 décrit la fabrication de modules électroniques pour cartes à microcircuit. Sont fabriqués d'une part, une bande en métal avec une pluralité d'ouvertures dans lesquelles pénètrent des langues et destinés à former des plages de contact. D'autre part, des palettes de matériau plastique sont placées à l'opposé les langues. Chaque palette est attachée par sa face avant aux langues dans chaque ouverture, une puce étant collée au fonds de la cavité. Des fils de connexion sont reliés à la puce et aux langues auxquelles la palette est attachée. Les fenêtres sont remplies d'un isolant adhésif.

Le document US4720690 décrit un conducteur d'interface linéaire sculpté. Un conducteur supérieur possède des perçages dans une deuxième section pour exposer un bloc de protection dans les pistes d'un circuit. La connexion à chaque conducteur est alors faite par les trous dans le conducteur supérieur. Le circuit est disposé adjacent à des trous rectangulaires et sont connectés aux pistes intérieures exposées via les trous rectangulaires.

Le document US4916808 décrit la fabrication d'un conducteur d'interface sculpté. Une première couche de terre et une couche diélectrique attachée sont perforés pour créer une première ouverture d'accès et des deuxièmes ouvertures d'accès. La connexion électrique est faite de manière espacée à distance des ouvertures d'accès. Une deuxième couche diélectrique incluant un recouvrement et un fonds, avec des couches en métal, est solidarisé au côté exposé de la première couche diélectrique. Avant cette solidarisation, la surface métallique supérieure du deuxième diélectrique est gravée pour former les pistes et une troisième ouverture d'accès est formée à travers les trois couches.

Le document US4960983 décrit une carte sans contact et un système pour le transfert d'information utilisant cette carte. Pour le transfert sans contact entre la carte IC et un lecteur de carte, la carte et le lecteur comprennent chacun une puce ayant un circuit logique et une bobine électromagnétique ment inductive pour le transfert d'information. Une alimentation d'énergie est placée au moins en partie sur la carte pour fournir une puissance électrique à la puce de la carte.

Le document US5055913 décrit un support de données à un circuit intégré et une méthode pour le produire. Pendant la production un élément de transporteur équipé d'un circuit intégré et de plages de contact est inséré dans une cavité du corps du support. Pour tenir compte de l'élément de transporteur à fixer dans la cavité, cet élément est pourvu d'un film adhésif apte à fondre. Pour protéger le circuit intégré de tensions mécaniques, le film est constitué d'un matériau à déformation élastique et placé entre le circuit et le film adhésif.

Le document US5055968 décrit une puce qui est d'abord positionnée sur deux bornes de contact d'une antenne, sur une première feuille. Ensuite, une deuxième feuille ayant une ouverture apte à entourer la puce, est scellée à la première feuille. Alors, les deux feuilles sont superposées et scellées ensembles par chauffage à 130°C ou par la fusion ultrasonique. Pour couvrir l'ouverture, un adhésif est alors disposé sur la deuxième feuille, qui est aussi scellé à la première feuille par fusion.

Le document US5067008 décrit un composant IC et une carte à puce incorporant ce composant. Ce composant inclut une cavité dans laquelle la puce est montée, une paroi entourant la puce et une cannelure formée dans la paroi environnant qui s'étend de manière à entourer la cavité et communiquer avec elle. Pour fabriquer le composant, une quantité de résine plus que nécessaire remplit la cavité et est pressée à l'aide d'une presse. L'excédent de résine débordant de la cavité est reçu dans la cannelure. En conséquence, la surface exposée de la résine est formée suivant une forme prédéterminée sans avoir besoin de rectification.

Le document US5206495 décrit une carte à mémoire capable de transmettre sélectivement des données par l'intermédiaire des contacts ou des enroulements de transmission. La carte inclut un dispositif d'élément de commutation, de préférence un multiplexeur, couplé entre un dispositif de semi-conducteur et les contacts dans un domaine de contact et des enroulements de transmission. Une tension transmise par l'intermédiaire des enroulements peut être opérationnelle pour placer automatiquement le multiplexeur pour la transmission par l'intermédiaire des enroulements.

Le document US5208450 décrit une carte à puce ou IC et une méthode pour sa fabrication. Cette carte possède un module IC collé à une première partie concave d'un corps de carte, au moyen d'un adhésif. Un trou est formé entre la surface extérieure du module IC et la surface intérieure de la première partie concave. Le trou est plus large dans la partie supérieure intérieure et plus étroit dans la partie inférieure intérieure de la première partie concave, pour que la puce et le corps de carte puissent être protégés de dommages causés par flexion.

Le document US5235736 décrit une méthode d'auto adhésion pour assembler une antenne / et un récepteur. Pour assembler antenne et récepteur, on forme un récepteur et une antenne dans un circuit imprimé de sorte que le matériau de l'antenne soit adjacent à et aligné au récepteur. Ensuite, l'antenne est électriquement connectée au récepteur tandis tout en restant aligné avec lui. Ensuite on sépare l'antenne et le récepteur.

Le document US5272596 décrit une carte de données personnelle fabriquée à partir d'un circuit sous forme de film épais en polymère. Ce film épais est formé d'une feuille de polymère ayant une pluralité de plages et des pistes de connexion imprimées avec une encre en polymère chargée de cuivre. Chacune des plages présente une couche de nickel et au-dessus une couche d'or appliqué, pour faciliter le soudage de fils entre une puce de semi-conducteur et une plage correspondante.

Le document US5321240 décrit une carte à puce IC à transmission de données sans contact. Cette carte présente a une grande résistance mécanique à la courbure et à la flexion, bien que mince, et permet le montage d'un de circuit intégré. Un cadre de renforcement rigide, électriquement conducteur est disposé sur le bord extérieur d'un circuit afin d'augmenter la résistance mécanique de la carte. Ce cadre de renforcement est électriquement connecté aux bornes d'une bobine en spirale sur circuit, qui possède une inductance définie par un circuit d'antenne.

Le document WO8702806 décrit une puce logée dans une ouverture d'un corps.

Le document WO8808592 décrit la fabrication d'une carte sans contact, où on ménage dans une couche du corps une cavité à l'intérieur de laquelle. Un module fixé à l'antenne est placé sur la couche du corps. Couche, module et antenne sont ensuite colaminées.

Le document WO9320537 décrit la connexion d'une antenne à un module, grâce à un raccord dit "socket", puis un surmoulage après encapsulation par lamination entre deux feuilles plastique.

La description sans caractère limitatif qui suit, se réfère aux dessins annexés, dans lesquels :
- la figure 1 montre, en coupe transversale, une carte sans contact hybride selon l'invention selon l'invention ;
- la figure 2 illustre, en vue de dessus à une étape au sein de l'équipement selon l'invention lors de laquelle on dispose une antenne sur une feuillé thermoplastique du corps de carte d'une carte, l'invention ;
- la figure 3 illustre en coupe transversale, l'invention montrée figure 2 ;
- la figure 4 est une vue de dessus à une étape au sein d'un l'équipement selon l'invention lors de laquelle on dépose une couche thermoplastique sur un ensemble feuille thermoplastique-antenne, d'un premier mode de réalisation de l'invention ;
- la figure 5 illustre en coupe transversale après une étape au sein d'un l'équipement selon l'invention de report du module dans une cavité, l'invention montrée figure 4 ;
- la figure 6 est une vue de dessus à une étape au sein d'un l'équipement selon l'invention lors de laquelle on dépose une couche thermoplastique sur un ensemble feuille thermoplastique-antenne, d'un second mode de réalisation de l'invention ;
- la figure 7 illustre le second mode de réalisation en coupe transversale à une étape au sein d'un l'équipement selon l'invention lors de laquelle de report du module dans une cavité de la carte.

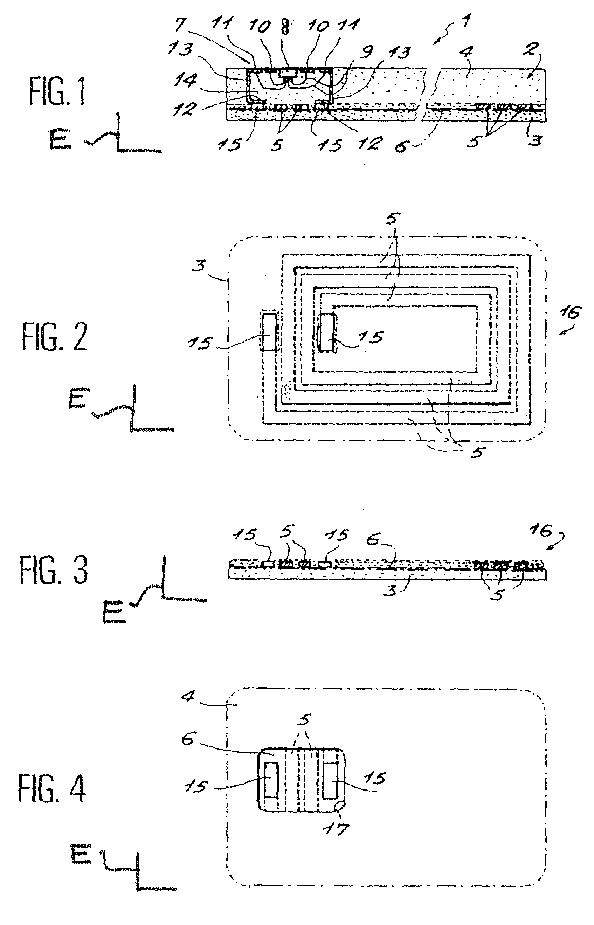

La figure 1 montre une carte 1 sans contact selon l'invention.

La carte 1 comporte un corps de carte 2 composé d'une feuille thermoplastique inférieure 3 et d'une couche thermoplastique supérieure 4.

Elle comporte aussi une antenne 5, disposée au-dessus de la feuille 3. Cette antenne 5 est éventuellement noyée dans une couche de colle 6 représentée en traits tirés.

La carte 1 comporte un module électronique 7, situé dans la couche 4, au-dessus de l'antenne 5. Ce module électronique 7 comprend une puce 8 à circuits intégrés connectée ici par l'intermédiaire de fils conducteurs 9, à un ensemble de plots métalliques 10 et 11 formant des métallisations. Les plots 10 et 11, dans un exemple au nombre de huit, sont situés au-dessus de la puce 8 et affleurent à la surface de la carte 1.

Seuls les plots 11, ici au nombre de deux, situés par exemple à la périphérie des métallisations, sont connectés en outre à deux plages de contact inférieures 12 du module 7. Cette connexion est ici réalisée par des fils conducteurs non représentés.

Dans une réalisation, la connexion entre les plots 11 et les plages inférieures 12, est réalisée par une bande conductrice qui serait disposée verticalement sur des faces latérales 13 du module 7, pliée en ses extrémités.

Le module 7 comprend une résine de protection 14, dans laquelle sont figés les différents éléments précités.

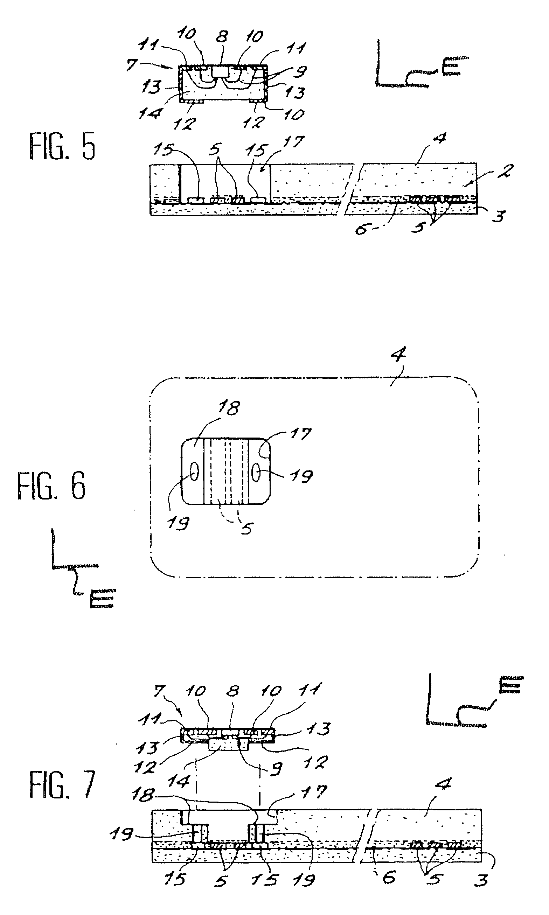

Les plages 12 sont en contact électrique avec deux bornes de contact 15 de l'antenne 5. Sur la figure 1, ce contact est direct. Sur la figure 7, le contact entre les plages 12 et les bornes 15 est réalisé par l'intermédiaire d'une résine conductrice. Dans un mode de réalisation non représenté, le contact entre les plages 12 et les bornes 15 est réalisé par une languette métallique à effet ressort.

L'invention propose de disposer préalablement l'antenne 5 sur la feuille thermoplastique 3, de manière à former un ensemble 16 : feuille 3 - antenne 5. Cette étape est réalisée sur un équipement désigné en E sur les figures 2 et 3.

L'antenne 5 est formée d'un diélectrique métallisé ou contre-collé avec du métal, une feuille de métal ou une bobine en fils. Elle est réalisée par l'équipement E en étant gravée chimiquement, par estampage ou par bobinage d'un fil ou par dépôt d'un promoteur d'adhérence sur la feuille thermoplastique 3 par sérigraphie puis métallisation par dépôt chimique.

Sur la figure 2, l'antenne 5 est disposée sur une face de la feuille 3 sous la forme d'une spirale 5 à trois spires dont les deux extrémités, c'est-à-dire les bornes de contact 15, sont localisées en regard et à proximité l'une de l'autre, l'une à l'intérieur et l'autre à l'extérieur de la spirale. L'antenne 5 peut avoir une configuration géométrique différente dans d'autres réalisations, le nombre de spires étant donné à titre indicatif seulement. Ainsi, la feuille 3 est métallisée double face et a des spires sur l'une et l'autre de ses faces.

On établit alors comme pour les circuits imprimés double faces, des trous métallisés de passage d'une face à l'autre. Ceci supprime la contrainte d'avoir à passer toutes les spires entre les bornes 15.

Aussi, par plusieurs opérations de sérigraphie successives, sont définies des spires multicouches.

Par ailleurs, dans le cas d'une antenne 5 hyperfréquences, sa configuration est rectangulaire à deux faces. L'antenne 5 hyperfréquences comporte une bande de cuivre sur sa face supérieure, un trou métallisé relie électriquement sa face inférieure à sa face supérieure. Une extrémité de la bande de cuivre ainsi que le trou métallisé constituent les bornes 15.

L'antenne 5 est réalisée dans l'épaisseur de la carte 1. Par son contour extérieur, l'antenne 5 épouse ici sensiblement les contours extérieurs de la feuille 3. Sa portée et ses capacités de réception, qui dépendent de la surface de flux magnétique qu'elle couvre, seront ainsi maximales pour la feuille 3 donnée.

La feuille thermoplastique 3 a sensiblement la longueur et la largeur de la carte 1, mais est ici légèrement plus petite de façon à la positionner dans un moule laissant un certain jeu latéral. Son épaisseur est de l'ordre de 0,180 mm pour une carte 1 correspondant à la norme ISO7810.

Cette feuille 3 est selon les réalisations en PVC (chlorure de polyvinyle), PC (poly carbonate), ABS (acrylonitrile butadiène styrène), PET (polyéthylène), PETG (téréphtalique -de polyéthylène glycol), PVDF (poly fluorure de vinylidène) ou équivalents.

Soit l'antenne 5, disposée sur la feuille de thermoplastique 3, est fixée par collage.

Soit l'antenne 5 est enduite et noyée dans de la colle thermo activable 6. La fixation est ainsi améliorée, et les bornes 11 ne sont pas enduites, ce qui facilite leur connexion au module 7. Parfois, cette enduction n'est pas nécessaire, l'adhérence étant obtenue, par exemple, par le ramollissement de la matière de la feuille 3 qui apparaît aux températures de mise en oeuvre de l'invention.

Selon l'invention, sur les figures 4 à 7, l'ensemble feuille thermoplastique - antenne 16 est recouvert à l'exception des bornes de, contact 15, de la couche thermoplastique 4.

Cette étape est réalisée sur l'équipement E par surmoulage. La matière utilisée pour la couche 4 est de l'ABS, un PC, de l'ABS/PC, du PET ou un polyamide.

Le moule sur l'équipement E comporte un dispositif permettant de plaquer l'ensemble 16, de manière à ce que pendant l'injection du thermoplastique de la couche 4, la feuille 3 reste en position contre l'une des faces du moule. Ce dispositif est formé par exemple par une pompe d'aspiration reliée à de petits orifices percés directement dans la face du moule où est plaquée la feuille 3.

Sur l'équipement E, le moule comporte un ou des noyaux qui couvrent les bornes 15 et réservent la place du module 7, pour former une cavité 17 (figures 4 à 7), dont les dimensions sont sensiblement complémentaires à celles du module 7. Ce noyau exerce une pression sur les bornes 15, telle qu'elles ne seront pas recouvertes par la couche 4 apparaissent au fond de la cavité 17. La forme du noyau donne à la cavité 17 son relief. Sur les figures 4 et 6 des cavités 17 sont à section rectangulaire, pour recevoir des modules 7 parallélépipédiques. Les cavités 17 sur la figure 5 a une découpe parallélépipédique à fond plat. La cavité 17 sur la figure 6 ou 7 a un plan 18, traversé par deux ouvertures verticales 19 de section oblongue qui débouchent sur les bornes 15.

Selon l'invention, le module 7 est reporté dans la cavité 17, comme sur les figures 5 et 7.

L'invention ne se limite pas à un module 7 reporté déjà complet dans la cavité 17. Par exemple, on peut reporter dans la cavité une puce 8 nue. Les deux plages 12 sont alors connectées aux bornes 15 avant le report de la puce 8. Les connexions aux plots 10 et 11, reportées en dernier lieu sont effectuées après le report de la puce 8, pour que les extrémités des fils 9 soient prêtes à recevoir les métallisations des plots 10 et 11.

Sur la figure 5, un module 7 parallélépipédique comporte face au fond de la cavité 17 à des côtés opposés, des plages de contact 21. Le module 17 reporté dans la cavité 17 a ses plages 12 directement au contact des bornes 15.

Le module 7 est fixé dans le fond de la cavité 17, ici par une colle cyanoacrylate ou dans une autre réalisation par une colle thermo activable ou un adhésif à froid.

À l'endroit des connexions, quelques gouttes de colle conductrice à base d'un époxy ou d'un acrylate chargé en argent fixent le module 7.

Sur la figure 7, le module 7 a ses plages 12 disposées dans sa partie supérieure, à proximité des métallisations des plots 10 et 11. Des faces latérales verticales 13 sont réduites par rapport à des hauteur du module 7. Dans un exemple, les plages 12 sont constituées par l'envers de la grille de métallisation remplaçant les fils 9 pour la réalisation des connexions.

Une fois le module 7 reporté dans la cavité 17, les plages 12 reposent sur le plan 18. Afin d'assurer une liaison électrique entre ces plages 12 et les bornes 15, les ouvertures 19 sont remplies d'un polymère conducteur tel qu'une pâte à braser, ou ici une colle conductrice. Selon une réalisation, sont disposés dans les ouvertures 19, des languettes 19, des languettes à ressort métalliques. Le module 7 est selon les réalisations, fixé dans la cavité 17 par une colle par exemple cyanoacrylate, par un adhésif à froid ou thermo activable.

Comme on le voit bien sur les figures 1, 3, 5 et 7, la carte 1 est agencée avec des bornes 15 au fond de la cavité 17, qui sont séparées par une couche 6 intégrée au corps 2 de la carte 1. Le cas échéant, cette couche 6 est traversée par des ouvertures au droit des bornes 15, remplies de polymère conducteur qui connecte le module 7 et l'antenne 5 ou par des languettes ou ressorts.

## Revendications

1. Carte (1) sans contact avec : un corps (2) de carte ; un module électronique (7) qui comprend une puce (8) à circuit intégré et des plages de contact (12) ; et une antenne (5) avec des bornes de contact (15) et reliée aux plages (12) par l'intermédiaire de ces bornes (15) ; **caractérisée par** une cavité (17) ménagée dans le corps (2) et laissant apparaître les bornes (12) de l'antenne (5) ; le module (7) étant reporté dans la cavité (17).

2. Carte (1) selon la revendication 1, **caractérisée en ce que** l'antenne (5) est disposée sur une feuille thermoplastique (3) du corps (2) de manière à former un ensemble (16) : feuille thermoplastique (3) et antenne (5).

3. Carte (1) selon la revendication 2, **caractérisée en ce que** l'antenne (5) est disposée sur la feuille thermoplastique (3) sous la forme d'une spirale dont les extrémités qui forment les bornes de contact (15), sont localisées en regard l'une de l'autre, l'une à l'intérieur et l'autre à l'extérieur de la spirale.

4. Carte (1) selon la revendication 2 ou 3, **caractérisée en ce que** l'antenne (5) disposée sur la feuille thermoplastique (3) est fixée sur la feuille (3) par collage.

5. Carte (1) selon la revendication 2 ou 3, **caractérisée en ce que** l'antenne (5) disposée sur la feuille thermoplastique (3) est fixée sur la feuille (3) par dépôt d'un promoteur d'adhérence sur la feuille thermoplastique (3) par sérigraphie puis métallisation par dépôt chimique.

6. Carte (1) selon l'une des revendications 1 à 3, **caractérisée en ce que** l'antenne (5), à l'exception de ses bornes (15) est enduite avec une colle thermo activable (6).

7. Carte (1) selon l'une des revendications 2 à 6, **caractérisée en ce que** l'ensemble (16) feuille (3) thermoplastique - antenne (5), à l'exception de ses bornes (15) est recouvert par une couche thermoplastique (4) en vue de former la cavité (17).

8. Carte (1) selon l'une des revendications 1 à 7, **caractérisée en ce que** la cavité (17) a un plan (18) percé d'ouvertures (19) au fond desquelles apparaissent les bornes de contact (15).

9. Carte (1) selon l'une des revendications 1 à 8, **caractérisée en ce que** le corps (2) de la carte (1) comporte une couche (6) sur l'antenne (5) à l'exception des bornes (15) au fond de la cavité (17), ces bornes (15) étant séparées par la couche (6) intégrée au corps (2) de carte (1).

10. Carte (1) selon la revendication 9, **caractérisée en ce que** la couche (6) est traversée par des ouvertures (19) au droit des bornes (15), remplies par la connexion du module (7) à l'antenne (5).

11. Carte (1) selon la revendication 10, **caractérisée en ce que** les ouvertures (19) sont remplies par : un polymère conducteur et / ou des languettes et / ou ressorts.

12. Carte (1) selon la revendication 11, **caractérisée en ce que** les ouvertures (19) sont remplies par un polymère conducteur tel qu'une pâte à braser et / ou une colle conductrice.

13. Carte (1) selon l'une des revendications 1 à 12, **caractérisée en ce qu'**un contour extérieur de l'antenne (5) épouse sensiblement des contours extérieurs de la feuille (3) thermoplastique.

14. Carte (1) selon l'une des revendications 1 à 13, **caractérisée en ce que** la feuille (3) thermoplastique a sensiblement la longueur et la largeur de la carte (1), par exemple est légèrement plus petite de façon à la positionner dans un moule en laissant un certain jeu latéral ; son épaisseur est de l'ordre de 0,180 mm ; cette feuille (3) est en PVC (chlorure de polyvinyle) et / ou PC (poly carbonate) et / ou ABS (acrylonitrile butadiène styrène) et / ou PET (polyéthylène) et / ou PETG (téréphtalique de polyéthylène glycol) et / ou PVDF (poly fluorure de vinylidène) ou équivalents.

15. Carte (1) selon l'une des revendications 1 à 14, **caractérisée en ce que** des languettes métalliques ou ressorts sont disposées dans des ouvertures (19) afin d'assurer une liaison électrique entre les plages (12) et les bornes (15).

16. Carte (1) selon l'une des revendications 1 à 15, **caractérisée en ce qu'**une cavité (17) est à section rectangulaire pour module (7) parallélépipédiques, par exemple une cavité (17) a une découpe parallélépipédique à fond plat ou la cavité (17) a un plan (18) traversé par deux ouvertures verticales (19) de section oblongue qui débouchent sur les bornes (15).

17. Équipement (E) de fabrication d'une carte (1) sans contact ; cette carte (1) portant un corps (2) de carte ; un module électronique (7) avec une puce (8) à circuit intégré et des plages de contact (12), une antenne (5) et des bornes de contact (15) ; cet équipement (E) comportant des moyens aptes à ménager dans le corps (2) une cavité (17) en laissant apparaître les bornes (12) de l'antenne (5) ; le des moyens aptes à reporter le module (7) dans la cavité (17) ; **caractérisé par** des moyens aptes à disposer préalablement l'antenne (5) sur une feuille thermoplastique (3) du corps (2) de manière à former un ensemble (16) : feuille thermoplastique (3) et antenne (5).

18. Équipement (E) selon la revendication 17, **caractérisé par** des moyens enduisent l'antenne (5), à l'exception de ses bornes (15), avec une colle thermo activable (6).

19. Équipement (E) selon la revendication 17 ou 18, **caractérisé par** des moyens recouvrent l'ensemble (16) feuille (3) thermoplastique - antenne (5), à l'exception de ses bornes (15), par une couche thermoplastique (4) en vue de former la cavité (17).

20. Équipement (E) selon l'une des revendications 17 à 19, **caractérisé par** des moyens disposent une couche (6) thermoplastique sur l'ensemble (16) feuille thermoplastique (3) et antenne (5), par moulage et comportent un noyau de recouvrement des bornes (15).

21. Équipement (E) selon l'une des revendications 17 à 20, **caractérisé par** des moyens de formation de la cavité (17) dans un plan (18) du corps (2) par perçage d'ouvertures (19) au fonds desquelles apparaissent les bornes (15).

22. Équipement (E) selon la revendication 20, **caractérisé par** des moyens de surmoulage pour recouvrir l'ensemble (16) feuille thermoplastique (3) et antenne (5).

23. Équipement (E) selon la revendication 20 ou 22, **caractérisé par** un moule sur l'équipement (E) qui comporte un dispositif permettant de plaquer l'ensemble (16), de manière à ce que pendant l'injection du thermoplastique de la couche, la feuille (3) reste en position contre une face de ce moule ; par exemple ce dispositif est formé par une pompe d'aspiration reliée à de petits orifices percés directement dans la face du moule où est plaquée la feuille (3).

24. Équipement (E) selon la revendication 23, **caractérisé en ce que** le moule comporte un ou des noyaux qui couvrent les bornes (15) et réservent la place du module (7), pour former la cavité (17) dont les dimensions sont sensiblement complémentaires à celles du module (7) ; par exemple ce noyau exerce une pression sur les bornes (15) telle qu'elles ne seront pas recouvertes par la couche et apparaissent au fond de la cavité (17) ; la forme du noyau donne à la cavité (17) son relief.

25. Équipement (E) selon l'une des revendications 17 à 24, **caractérisé par** des moyens de remplissage d'ouvertures (19) dans le corps (2) par un polymère conducteur tel que pâte à braser et / ou colle conductrice afin d'assurer une liaison électrique entre les plages (12) et les bornes (15).

26. Équipement (E) selon l'une des revendications 17 à 24, **caractérisé par** des moyens de remplissage d'ouvertures (19) dans le corps (2) par des languettes et / ou ressorts afin d'assurer une liaison électrique entre les plages (12) et les bornes (15).

27. Équipement (E) selon l'une des revendications 17 à 26, **caractérisé par** des moyens d'intégration au corps (2) d'une couche de séparation des bornes 15 au fond de la cavité 17.
